# EUROPEAN PATENT APPLICATION

(11) **EP 2 711 180 A2**
(43) Date of publication of application: **26.03.2014**
(21) Application number: 12785782.9
(22) Date of filing: 16.05.2012
(51) Int. Cl.: B32B 27/08, B32B 7/12, C08L 83/04, C08L 67/04, B32B 27/18

(54) **MULTI-LAYER PLASTIC SUBSTRATE AND METHOD FOR MANUFACTURING SAME**

(30) Priority: 16.05.2011 KR 20110045908; 16.05.2011 KR 20110045910; 16.05.2011 KR 20110045911; 16.05.2011 KR 20110045913; 16.05.2011 KR 20110045914; 16.05.2012 KR 20120051959
(71) Applicant: LG Chem, Ltd., Seoul 150-721 (KR)
(72) Inventor: MA, Seung Lac, Cheongju-si Chungbuk 361-768 (KR); KIM, Dong Ryul, Daejeon 305-721 (KR); HWAN, Jang Yeon, Seoul 158-070 (KR); KIM, Gi Cheul, Daejeon 305-380 (KR); KO, Myeong Geun, Seoul 156-807 (KR); RYU, Sang Uk, Daejeon 305-761 (KR); LEE, Ho Jun, Daejeon 305-380 (KR)
(74) Representative: Goddar, Heinz J.
(86) International application number: PCT/KR2012/003855
(87) International publication number: WO 2012/157960

(57) **Abstract**

A multi-layered plastic substrate is provided, in which a first organic or organic-inorganic hybrid layer, a gas barrier layer and a second organic or organi-inorganic hybrid layer are stacked on both surfaces of two plastic films joined to each other. At least one of the first and second organic or organic-inorganic hybrid layers is formed of a composition including at least one of: at least one organic silane selected from the group consisting of compounds represented by Formula 1, polycaprolactone, polytetrahydrofuran, epoxy and xylene glycol.

## Description

### CROSS-REFERENCE TO RELATED APPLICATION

This application claims priority to and the benefit of Korean Patent Application No. 2011-0045908, filed May 16, 2011; 2011-0045910 filed May 16, 2011, 2011-45911 filed May 16, 2011, 2011-45913 filed May 16, 2011, 2011-0045914 filed May 16, 2011, and 2012-0051959 filed May 16, 2012, the disclosure of which is incorporated herein by reference in its entirety.

### BACKGROUND

### 1. Field of the Invention

The present invention relates to a multi-layered plastic substrate and a method of manufacturing the same, and particularly, to a multi-layered plastic substrate capable of realizing an excellent gas barrier property, a high surface hardness, and a good moisture barrier property, and a method of manufacturing the same.

### 2. Discussion of Related Art

A glass substrate used in a display device, a picture frame, arts and crafts, or a container has various advantages of a low coefficient of linear expansion, an excellent gas barrier property, a high degree of light penetration, a high surface roughness, an excellent thermal resistance, and an excellent chemical resistance, but the glass substrate is easily broken due to a low shock resistance, and is heavy due to a high density.

In recent years, growing attention to liquid crystals, organic light emitting devices, and electronic paper has led to active research into changing a substrate for such a display device from glass to plastic. When the glass substrate is replaced with the plastic substrate, an overall weight of the display device may be reduced and flexibility in a design of the display device may be ensured. In addition, the plastic substrate has a high shock resistance and may have a higher economic feasibility than the glass substrate when it is manufactured in continuous processes.

Meanwhile, to be used in the display device, the plastic substrate requires a processing temperature of a transistor diode, a high glass transition temperature capable of tolerating a deposition temperature of a transparent electrode, oxygen and moisture barrier properties to prevent aging of a liquid crystal and an organic light emitting material, a low coefficient of linear expansion and dimensional stability to prevent distortion of the substrate according to a change in the processing temperature, a high mechanical strength compatible with a process apparatus used for the conventional glass substrate, a chemical resistance capable of tolerating an etching process, a high degree of light penetration and a low birefringence, and surface scratch resistance.

However, since there is no high-functional polymer base film (including a polymer film and a polymer-inorganic material composite film) satisfying these requirements, attempts have been made to provide the above-described physical properties by performing multi-layered functional coating on the polymer base film. As an example of a representative coating layer, an organic planarization layer reducing a surface defect of a polymer and giving a planarization characteristic, a gas barrier layer composed of an inorganic material to block gas such as oxygen and moisture, or an organic or organic-inorganic hard coating layer giving a scratch resistance to the surface of the polymer may be used. Conventionally, a number of multi-layered plastic substrates are subjected to coating an inorganic gas barrier layer on a polymer base material and then coating a hard coating layer on the gas barrier layer. In the manufacture of this multi-layered structure, deformation of a polymer base material according to large difference in coefficient of linear expansion between the polymer base material and the gas barrier layer, and cracks and delamination of an inorganic thin film, may occur. Therefore, it is very important to design a suitable multi-layered structure capable of minimizing stress at an interface between layers and ensure a suitable adhesive property between coating layers.

Vitex Systems in the U.S.A. manufactured a multi-layered organic-inorganic layer and a flexible substrate having an excellent gas barrier property by repeatedly performing a process including forming a monomer thin film on a polymer base film, irradiating the monomer thin film with UV rays to induce polymerization (to form a solidified organic layer), and forming an inorganic thin film on the solidified organic layer by sputtering. While a product having an excellent gas barrier property may be obtained according to this method, the product is not suitable for a display demanding a low coefficient of linear expansion, and no solution to this problem has been provided.

In addition, U.S. Patent No. 6,465,953 discloses a method of dispersing getter particles capable of reacting with input oxygen and moisture on a plastic substrate when the plastic substrate is used in an organic light emitting device sensitive to oxygen and moisture. The getter particles should have a sufficiently smaller size than a characteristic wavelength of emitted light and be evenly dispersed to penetrate the substrate without scattering the emitted light. In addition, the method attempts to minimize amounts of the input oxygen and moisture by coating a gas barrier film composed of an inorganic material on the plastic substrate. However, according to the method, there is a high chance of cracking or delamination of the gas barrier film according to a temperature change because it is difficult to manufacture the substrate by evenly dispersing 100 to 200 nm-sized nanoparticles, the plastic substrate should have a large thickness to contain a large amount of the getter particles capable of reacting with the oxygen and moisture, and the inorganic gas barrier film is directly coated on the plastic substrate.

According to U.S. Patent No. 6,322,860, a plastic substrate for a display device is manufactured by coating a crosslinkable composition (a polyfunctional acrylate-based monomer or oligomer, alkoxy silane, or a mixture thereof) optionally including silica particles, etc. on one or both surfaces of a polyglutarimide sheet having a thickness within 1 mm, prepared by reactive extrusion, photocuring or thermally curing the composition to manufacture a crosslinked coating film, coating a gas barrier film thereon, and optionally coating the crosslinked coating film on the barrier film again. However, according to the method, the plastic substrate has oxygen permeability and moisture permeability that are just low enough to be used in a liquid crystal display device in some specific cases, but still does not have any improvements, such as a low coefficient of linear expansion and excellent dimensional stability, that are essential for it to be used as a substrate replacing glass.

U.S. Patent No. 6,503,634 discloses a multi-layered film having a degree of oxygen penetration that is less than 1/30 of a polymer base material before coating, and a degree of moisture penetration that is less than 1/40 of the polymer base material before coating, by coating an organic-inorganic hybrid, ORMOCER and a silicon oxide layer on one polymer base material or in-between two polymer base materials. According to the method, the oxygen and moisture permeabilities are considerably decreased compared with the polymer base material before coating, and thus the film is likely to be used as a packaging material, but there is no mention of any improvement in the coefficient of linear expansion and dimensional stability.

### SUMMARY OF THE INVENTION

The present invention is directed to providing a multi-layered plastic substrate providing an excellent gas barrier property and having a high surface hardness and an excellent moisture barrier property, and a method of manufacturing the same.

One aspect of the present invention provides a multi-layered plastic substrate and an electronic device including the same.

In one example, the multi-layered plastic substrate according to the present invention includes a first organic or organic-inorganic hybrid layer; a gas barrier layer; and a second organic or organic-inorganic hybrid layer, which are stacked on both surfaces of two plastic films joined to each other. At least one of the first organic or organic-inorganic hybrid layer and second organic or organic-inorganic hybrid layer is formed of a composition including at least one selected from the group consisting of at least one organic silane selected from the group consisting of compounds represented by Formula 1, polycaprolactone, polytetrahydrofuran, epoxy and xyleneglycol.

[Formula 1] (R¹)ₘ-Si-X₍₄₋ₘ₎

In Formula 1, X may be the same as and different from each other, and represents hydrogen, halogen, or alkoxy, acyloxy, alkylcarbonyl, alkoxycarbonyl, having 1 to 12 carbon atoms, or -N(R²)₂, wherein R² is hydrogen or alkyl having 1 to 12 carbon atoms, R¹ may be the same as and different from each other, and represents alkyl, alkenyl, alkynyl, aryl, arylalkyl, alkylaryl, arylalkenyl, alkenylaryl, arylalkynyl, alkynylaryl group, having 1 to 12 carbon atoms, or halogen, substituted amino, amide, aldehyde, ketone, alkylcarbonyl, carboxyl, mercapto, cyano, hydroxyl, alkoxy having 1 to 12 carbon atoms, alkoxycarbonyl having 1 to 12 carbon atoms, sulfonic acid, phosphoric acid, acryloxy, methacryloxy, epoxy, or vinyl group, and m is an integer of 1 to 3.

In one example, in the definition of Formula 1, a structure of -(R¹)ₘ-O-Si-X₍₄₋ₘ₎ or (R¹)ₘ-NR²-Si-X₍₄₋ₘ₎ may be formed by inserting oxygen or -NR³ (here, R³ is hydrogen or alkyl having 1 to 12 carbon atoms) between radical R¹ and Si-.

The multi-layered plastic substrate according to the present invention may provide a low coefficient of linear expansion and an excellent pencil hardness. In one example, the multi-layered plastic substrate may have a coefficient of linear expansion of 20 ppm/K or less during measurement under conditions according to ASTM D696. In another example, the multi-layered plastic substrate may have a pencil hardness of 4H or 5H or more under conditions according to ASTM D3363, applying a load of 200 g.

In the multi-layered plastic substrate according to the present invention, at least one of the first organic or organic-inorganic hybrid layer and the second organic or organic-inorganic hybrid layer may further include at least one metal alkoxide selected from the group consisting of compounds represented by Formula 2.

[Formula 2] M-(R⁴)_{z}

In Formula 2, M is at least one metal selected from the group consisting of aluminum, zirconium and titanium, R⁴ may be the same as and different from each other, and represents halogen, or alkyl, alkoxy, acyloxy, having 1 to 12 carbon atoms, or hydroxyl, and z is an integer of 3 or 4.

For example, at least one of the first and second organic or organic-inorganic hybrid layers may further include at least one of: at least one filler selected from the group consisting of metal, glass powder, diamond powder, silicon oxide, clay, calcium phosphate, magnesium phosphate, barium sulfate, aluminum fluoride, calcium silicate, magnesium silicate, barium silicate, barium carbonate, barium hydroxide, and aluminum silicate; a solvent; and a polymerization catalyst.

Respective thicknesses of the first and second organic or organic-inorganic hybrid layers may be, for example, in a range of 0.1 to 50 µm, but the present invention is not limited thereto.

Surface roughnesses of the first and second organic or organic-inorganic hybrid layers may be 0.1 and 1.2 Ra, respectively.

The gas barrier layer may be formed of at least one inorganic material selected from the group consisting of SiOₓ (here, x is an integer of 1 to 4), SiOₓN_{y} (here, x and y are integers between 1 and 3), Al₂O₃ and ITO.

The gas barrier layer may have a thickness of 5 to 1000 nm.

The plastic film may be formed of at least one material selected from the group consisting of a single polymer, a blend of at least two polymers, and a polymer composite material containing an organic or inorganic additive. Each of the two plastic films may have a thickness of 10 to 2000 µm.

The present invention may further include a joining layer formed between the two plastic films. The joining layer may be formed using an acryl-based adhesive or by a thermal adhesion method. The joining layer may have a thickness of 0.1 to 10 µm.

The present invention provides an electronic device including the multi-layered plastic substrate described above.

Another aspect of the present invention provides a method of manufacturing a multi-layered plastic substrate, including: a) forming a first organic or organic-inorganic hybrid layer by coating an organic or organic-inorganic hybrid composition on one surface of a plastic film and curing the composition; b) forming a gas barrier layer on the first organic or organic-inorganic hybrid layer; c) forming a multi-layered film by coating an organic or organic-inorganic hybrid composition on the gas barrier layer, curing the composition and forming a second organic or organic-inorganic hybrid layer; d) further forming another multi-layered film of the same kind as formed in step c) by repeating the process including step a) to step c); and e) forming a symmetric structure by joining surfaces of the plastic films, on which the multi-layered films are not formed according to steps c) and d). Here, the organic-inorganic hybrid composition used in at least one of steps a) and c) includes at least one selected from the group consisting of at least one organic silane selected from the group consisting of compounds represented by Formula 1, polycaprolactone, polytetrahydrofuran, epoxy and xyleneglycol.

[Formula 1] (R¹)ₘ-Si-X₍₄₋ₘ₎

In Formula 1, X may be the same as and different from each other, and represents hydrogen, halogen, or alkoxy, acyloxy, alkylcarbonyl, alkoxycarbonyl, having 1 to 12 carbon atoms, or -N(R²)₂, wherein R² is hydrogen or alkyl having 1 to 12 carbon atoms, R¹ may be the same as and different from each other, and represents alkyl, alkenyl, alkynyl, aryl, arylalkyl, alkylaryl, arylalkenyl, alkenylaryl, arylalkynyl, alkynylaryl group, having 1 to 12 carbon atoms, or halogen, substituted amino, amide, aldehyde, ketone, alkylcarbonyl, carboxyl, mercapto, cyano, hydroxyl, alkoxy having 1 to 12 carbon atoms, alkoxycarbonyl having 1 to 12 carbon atoms, sulfonic acid, phosphoric acid, acryloxy, methacryloxy, epoxy, or vinyl group, and m is an integer of 1 to 3.

In one example, in the definition of Formula 1, a structure of -(R¹)ₘ-O-Si-X₍₄₋ₘ₎ or (R¹)ₘ-NR²-Si-X₍₄₋ₘ₎ may be formed by inserting oxygen or -NR³ (here, R³ is hydrogen or alkyl having 1 to 12 carbon atoms) between radical R¹ and Si-.

In the method of manufacturing a multi-layered plastic substrate, the composition for forming the organic-inorganic hybrid layer further includes at least one metal alkoxide selected from the group consisting of compounds represented by Formula 2.

[Formula 2] M-(R⁴)_{z}

In Formula 2, M is at least one metal selected from the group consisting of aluminum, zirconium and titanium, R⁴ may be the same as and different from each other, and represents halogen, or alkyl, alkoxy, acyloxy, having 1 to 12 carbon atoms, or hydroxyl, and z is an integer of 3 or 4.

For example, the composition for forming the organic-inorganic hybrid layer may further include at least one of: at least one filler selected from the group consisting of metal, glass powder, diamond powder, silicon oxide, clay, calcium phosphate, magnesium phosphate, barium sulfate, aluminum fluoride, calcium silicate, magnesium silicate, barium silicate, barium carbonate, barium hydroxide, and aluminum silicate; a solvent; and a polymerization catalyst.

Respective thicknesses of the first and second organic or organic-inorganic hybrid layers may be in a range of 0.1 to 50 µm.

In addition, the joining method in step e) may be an adhesion method using an acryl-based adhesive, or an adhesion method using thermal curing.

### BRIEF DESCRIPTION OF THE DRAWINGS

The above and other objects, features and advantages of the present invention will become more apparent to those of ordinary skill in the art by describing in detail exemplary embodiments thereof with reference to the attached drawings, in which:
FIG. 1 is a schematic cross-sectional view of a multi-layered plastic substrate according to an exemplary embodiment of the present invention; and
FIG. 2 is a schematic diagram illustrating a process of manufacturing a multi-layered plastic substrate according to the present invention.

### DETAILED DESCRIPTION OF EXEMPLARY EMBODIMENTS

Hereinafter, exemplary embodiments of the present invention will be described in detail. However, the present invention is not limited to the embodiments disclosed below, but can be implemented in various forms. The following embodiments are described in order to enable those of ordinary skill in the art to embody and practice the present invention.

Although the terms first, second, etc. may be used to describe various elements, these elements are not limited by these terms. These terms are only used to distinguish one element from another. For example, a first element could be termed a second element, and, similarly, a second element could be termed a first element, without departing from the scope of exemplary embodiments. The term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

The terminology used herein is for the purpose of describing particular embodiments only and is not intended to be limiting of exemplary embodiments. The singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements, components and/or groups thereof, but do not preclude the presence or addition of one or more other features, integers, steps, operations, elements, components and/or groups thereof.

With reference to the appended drawings, exemplary embodiments of the present invention will be described in detail below. To aid in understanding the present invention, like numbers refer to like elements throughout the description of the figures, and the description of the same elements will be not reiterated.

A multi-layered plastic substrate according to an exemplary embodiment of the present invention includes a first organic or organic-inorganic hybrid layer; a gas barrier layer; and a second organic or organic-inorganic hybrid layer, which are stacked on both surfaces of two plastic films joined to each other. At least one of the first organic or organic-inorganic hybrid layer and second organic or organic-inorganic hybrid layer is formed of a composition including at least one selected from the group consisting of at least one organic silane selected from the group consisting of compounds represented by Formula 1, polycaprolactone, polytetrahydrofuran, epoxy and xyleneglycol.

[Formula 1] (R¹)ₘ-Si-X₍₄₋ₘ₎

In Formula 1, X may be the same as and different from each other, and represents hydrogen, halogen, or alkoxy, acyloxy, alkylcarbonyl, alkoxycarbonyl, having 1 to 12 carbon atoms, or -N(R²)₂, wherein R² is hydrogen or alkyl having 1 to 12 carbon atoms, R¹ may be the same as and different from each other, and and represents alkyl, alkenyl, alkynyl, aryl, arylalkyl, alkylaryl, arylalkenyl, alkenylaryl, arylalkynyl, alkynylaryl group, having 1 to 12 carbon atoms, or halogen, substituted amino, amide, aldehyde, ketone, alkylcarbonyl, carboxyl, mercapto, cyano, hydroxyl, alkoxy having 1 to 12 carbon atoms, alkoxycarbonyl having 1 to 12 carbon atoms, sulfonic acid, phosphoric acid, acryloxy, methacryloxy, epoxy, or vinyl group, and m is an integer of 1 to 3.

In one example, in the definition of Formula 1, a structure of -(R¹)ₘ-O-Si-X₍₄₋ₘ₎ or (R¹)ₘ-NR²-Si-X₍₄₋ₘ₎ may be formed by inserting oxygen or -NR³ (here, R³ is hydrogen or alkyl having 1 to 12 carbon atoms) between radical R¹ and Si-.

The multi-layered plastic substrate according to the present invention may provide a low coefficient of linear expansion and an excellent pencil hardness. In one example, the multi-layered plastic substrate may have a coefficient of linear expansion of 20, 18, 16, 12 or 10 ppm/K or less, and in some cases, 0.1 to 20 ppm/K, 1 to 20 ppm/K, 5 to 20 ppm/K, 8 to 20 ppm/K, 8 to 16 ppm/K, 8 to 12 ppm/K, or 12 to 16 ppm/K during measurement under conditions according to ASTM D696. In another example, the multi-layered plastic substrate may have a pencil hardness of 4 or 5H or more, and in some cases, 3.5 to 7H, 4 to 7H or 4 to 6H under conditions according to ASTM D3363, applying a load of 200 g.

For example, the multi-layered plastic substrate may have a symmetric, laminated structure. In this structure, an organic-inorganic hybrid buffer layer may be disposed between a plastic film and a gas barrier layer, and on the gas barrier layer, thereby minimizing a difference in coefficient of linear expansion between layers and improving an inter-layer adhesive strength. In addition, since the multi-layered plastic substrate has a symmetric structure, the plastic substrate is not crooked in one direction according to a temperature change.

The plastic film of the multi-layered plastic substrate according to the present invention may be formed of at least one selected from the group consisting of a single polymer, a blend of at least two polymers, and a polymer composite material containing an organic or inorganic additive.

When the multi-layered plastic substrate is used as a substrate of a liquid crystal display device, since a process of forming a thin film transistor and a transparent electrode is performed at a high temperature of 200 °C or more, in the preparation of the plastic film, a polymer having high thermal resistance, which can tolerate the high temperature, is needed. As the polymer having such a characteristic, polynorbornene, aromatic fluorene polyester, polyethersulfone, bisphenol-A polysulfone or polyimide may be used. In recent years, as research to reduce a substrate processing temperature from a high temperature to a low temperature progresses, a polymer available at approximately 150 °C, such as polyethyleneterephthalate, polyethylenenaphthalene, polyacrylate, polycarbonate or a cyclic olefin copolymer, may be also used.

In still another example, the present invention may use a plastic film in which nano materials are dispersed in a polymer. Such a polymer composite material may be a polymer-clay nanocomposite, which may improve physical properties such as a mechanical property, thermal resistance, a gas barrier property and dimensional stability using a small amount of clay, due to a small particle size (< 1 micron) and a high aspect ratio of the clay, compared with a conventional composite such as glass fiber. That is, to improve these physical properties, it is important that a clay layer formed in a lamella structure is delaminated and evenly dispersed in a polymer matrix. The polymer-clay composite satisfies this condition.

The polymer which can be used in the polymer-clay composite may be polystyrene, polymethacrylate, polyethyleneterephthalate, polyethylenenaphthalene, polyarylate, polycarbonate, a cyclic olefin copolymer, polynorbornene, aromatic fluorene polyester, polyethersulfone, polyimide, an epoxy resin, or a multifunctionalized acrylate, and the clay may be laponite, montmorillonite, or megadite.

A thickness of each of the two plastic films may be 10 to 2000 µm, 10 to 1500 µm, 10 to 1000 µm, 10 to 600 µm, 100 to 2000 µm, 500 to 2000 µm, or 900 to 1500 µm. When the plastic film is formed to the above thickness, the thermal resistance and hardness required for the present invention may be satisfied.

The plastic film may be manufactured by a solution casting method or a film extruding process, and may be briefly annealed for several seconds to minutes at approximately the glass transition temperature to minimize distortion according to the temperature after the manufacture of the plastic film. After the annealing, to improve coatability and an adhesive property, a surface of the plastic film may be treated by primer coating, plasma treatment using corona, oxygen or carbon dioxide, UV-ozone treatment, or ion beam treatment in which a reactive gas is input.

A joining layer may be further included between the two plastic films, and may be formed using an acryl-based adhesive or by a thermal joining method. However, the method of forming the joining layer is not limited thereto. When the joining layer is formed using an adhesive, the joining layer may have a thickness of, but not specifically limited to, 0.1 to 10 µm, 0.3 to 10 µm, 0.4 to 10 µm, 1 to 10 µm, 0.1 to 8 µm, or 1 to 5 µm.

The gas barrier layer may be a high density inorganic material layer having a low coefficient of linear expansion, and may block a gas such as oxygen and moisture.

The method of forming the gas barrier layer may be performed by physically or chemically deposition coating a transparent inorganic material having a high density or a metal thin film having a nanometer-sized thickness on a polymer film to block oxygen and moisture, because a degree of oxygen penetration and a degree of moisture penetration of the plastic film itself usually have values of several tens to thousands of units.

Here, in the case of the transparent inorganic oxide thin film, when a defect such as a pin hole or crack is generated, it is difficult to sufficiently block oxygen and moisture, and in the case of the metal thin film having a small thickness, it is difficult to form a thin film having a uniform thickness of several nanometers without defects, and to have a degree of light penetration in a visible ray region of more than 80%.

Here, the deposition coating method to form the gas barrier layer may be sputtering, chemical deposition, ion plating, plasma chemical deposition or a sol-gel method.

The gas barrier layer formed by the above-mentioned method may have a thickness of 5 to 1000 nm, 20 to 1000 nm, 10 to 500 nm, 50 to 200 nm, 600 to 1000 nm or 600 to 800 nm. When the gas barrier layer has a thickness in the above range, an excellent gas barrier effect may be realized.

An inorganic material for forming the gas barrier layer may be at least one selected from the group consisting of SiOₓ (here, x is an integer of 1 to 4), SiOₓN_{y} (here, x and y are integers of 1 to 3, respectively), Al₂O₃ and ITO.

The first organic or organic-inorganic hybrid layer serves to improve an adhesive strength between the plastic film and the gas barrier layer by reducing the difference in coefficient of linear expansion between the plastic film and the gas barrier layer, and suitably controlling compositions of the organic and inorganic materials.

The first organic or organic-inorganic hybrid layer may planarize the surface of the plastic film, and thus minimize a defect generated in deposition of the gas barrier layer.

In a concrete way, an average surface roughness (Ra) of the first organic or organic-inorganic hybrid layer is a very important factor. Accordingly, when the layer is not planarized, defects may be generated during the deposition of the gas barrier layer, and thus a barrier property may not be exhibited. In other words, as a value of the surface roughness decreases, the barrier property increases. Accordingly, the surface roughness of the first organic or organic-inorganic hybrid layer may be approximately 1 nm, and preferably within 1 nm. Specifically, the surface roughness may have a Ra value of 0.1 to 1.2, 0.1 to 1.0, 0.5 to 1.2, 0.1 to 0.5, or 0.2 to 1.0.

The second organic or organic-inorganic hybrid layer serves as a protective layer for preventing a crack in the gas barrier layer, and covers the defects of the gas barrier, thereby further improving a gas barrier property. The second organic or organic-inorganic hybrid layer may also serve to give chemical resistance and scratch resistance, and reduce an electrical resistance due to an excellent planarization function in formation of a transparent conductive film.

In addition, in the present invention, the defects such as a pin hole, a crack, etc. which may be present in the inorganic material layer are cured due to hydrogenation occurring between a hydroxyl group of the inorganic material layer and a hydroxyl group of the second organic or organic-inorganic hybrid layer at a part having the defects of the inorganic material layer, which is the gas barrier layer, and thus the gas barrier property is further improved.

A composition of the second organic or organic-inorganic hybrid layer stacked on the gas barrier layer may be the same as that of the first organic or organic-inorganic hybrid layer coated on the plastic film, but may have a different ratio between an organic silane, a metal alkoxide and a filler, and a different thickness of coating the composition.

The surface roughness of the second organic or organic-inorganic hybrid layer is also a very important factor. Since elements such as ITO used in an LCD or OLED process are directly deposited on the second organic or organic-inorganic hybrid layer, the elements do not function properly due to a current concentration phenomenon when the surface roughness is high. A current trend requires a higher surface roughness in a next generation display, an OLED, than in an LCD. Therefore, in the present invention, to satisfy such a condition, the surface roughness of the second organic or organic-inorganic hybrid layer may also be approximately 1 nm, and preferably, within 1 nm. Specifically, the surface roughness may have a Ra value of 0.1 to 1.2, 0.1 to 1.0, 05 to 1.2, 0.1 to 0.5, or 0.2 to 1.0.

A thickness of each of the first and second organic or organic-inorganic hybrid layers may be 0.1 to 50 µm. That is, each of the first and second organic or organic-inorganic hybrid layers may have a thickness of 0.1 to 50 µm, 2 to 10 µm, or 1 to 5 µm, after a composition as will be described later is coated and then cured on the plastic film.

When a gas barrier layer, which is an inorganic material layer, is stacked on the first organic or organic-inorganic hybrid layer formed as described above, an adhesive strength between the inorganic material layer and the first organic or organic-inorganic hybrid layer may be increased, a gas barrier property is improved due to the inorganic material layer, and mechanical properties of the entire substrate may also be improved due to a high modulus and a low coefficient of linear expansion of the inorganic material layer.

The first and/or second organic or organic-inorganic hybrid layer(s) is/are formed of a composition including at least one organic silane selected from the group consisting of compounds represented by Formula 1 and polycaprolactone.

The first and/or second organic or organic-inorganic hybrid layer(s) may be obtained by partially hydrolyzing the composition into a sol-type solution, coating, and then curing the solution on the plastic film.

The coating method may be spin coating, roll coating, bar coating, dip coating, gravure coating, or spray coating.

The method of curing the sol-type solution may be thermal curing, UV curing, IR curing, or high-frequency thermal treatment.

The organic silane may be at least one selected from the group consisting of compounds represented by Formula 1. Here, when the organic silane compound is used alone, the organic silane compound should be crosslinkable.

The organic silane may be selected from the group consisting of methyltrimethoxysilane, methyltriethoxysilane, phenyltrimethoxysilane, phenyltriethoxysilane, dimethyldimethoxysilane, dimethyldiethoxysilane, diphenyldimethoxysilane, diphenyldiethoxysilane, phenyldimethoxysilane, phenyldiethoxysilane, methyldimethoxysilane, methyldiethoxysilane, phenylmethyldimethoxysilane, phenylmethyldiethoxysilane, trimethylmethoxysilane, trimethylethoxysilane, triphenylmethoxysilane, triphenylethoxysilane, phenyldimethylmethoxysilane, phenyldimethylethoxysilane, diphenylmethylmethoxysilane, diphenylmethylethoxysilane, dimethylethoxysilane, dimethylethoxysilane, diphenylmethoxysilane, diphenylethoxysilane, 3-aminopropyltriethoxysilane, 3-glycidoxypropyltrimethoxysilane, p-aminophenylsilane, alkyltrimethoxysilane, n-(2-aminoethyl)-3-aminopropyltrimethoxysilane, 3-aminepropyltriethoxysilane, 3-aminopropyltrimethoxysilane, 3-glycidoxypropyldiisopropyl ethoxysilane, (3-glycidoxypropyl)methyldiethoxysilane, 3-glycidoxypropyltrimethoxysilane, 3-mercaptopropyltrimethoxysilane, 3-mercaptopropyltri ethoxysilane, 3-methacryloxypropylmethyldiethoxysilane, 3-methacryloxypropylmethyldimethoxysilane, 3-methacryloxypropyltrimethoxysilane, n-phenylaminopropyltrimethoxysilane, vinylmethyldiethoxysilane, ethoxysilane, vinyltrimethoxysilane, and mixtures thereof.

A multi-layered plastic substrate having an excellent gas barrier property may be manufactured by adding the polycaprolactone to the composition for forming the first and/or second organic or organic-inorganic hybrid layer.

As described above, as the polycaprolactone is added, the multi-plastic substrate that may satisfy basically required characteristics such as a high surface hardness, a moisture barrier property and chemical resistance and have an excellent gas barrier property may be manufactured.

The composition may further include at least one metal alkoxide selected from the group consisting of compounds represented by Formula 2.

[Formula 2] M-(R⁴)_{z}

In Formula 2, M is at least one metal selected from the group consisting of aluminum, zirconium and titanium, R⁴ may be the same as and different from each other, and represents halogen, or alkyl, alkoxy, acyloxy, having 1 to 12 carbon atoms, or hydroxyl, and z is an integer of 3 or 4.

For example, at least one of the first and second organic or organic-inorganic hybrid layers may further include at least one of: at least one filler selected from the group consisting of metal, glass powder, diamond powder, silicon oxide, clay, calcium phosphate, magnesium phosphate, barium sulfate, aluminum fluoride, calcium silicate, magnesium silicate, barium silicate, barium carbonate, barium hydroxide, and aluminum silicate; a solvent; and a polymerization catalyst.

Likewise, the composition for forming the first and/or second organic or organic-inorganic hybrid layer(s) may include at least one selected from the group consisting of organic silane, polycaprolactone, tetrahydrofuran, epoxy and xyleneglycol, and further include metal alkoxide and/or a filler. In some cases, a suitable additive, solvent and polymerization catalyst may be further included.

Here, the solvent may be a solvent used in conventional partial hydrolysis, and preferably distilled water.

The polymerization catalyst is not specifically limited, and may be at least one of aluminum butoxide and zirconium propoxide.

Amounts of the filler, solvent and catalyst used herein may be determined according to need, but are not specifically limited.

One or both of the first and second organic or organic-inorganic hybrid layers may be formed of the composition. Alternatively, one of the first and second organic or organic-inorganic hybrid layers may be formed of the composition, but the other one may be formed of the above-described composition having the same components except that epoxy or polytetrahydrofuran (PTHF) is added instead of polycaprolactone. Here, when the PTHF is added, the moisture barrier property may be improved, and when the epoxy is added, a high surface hardness may be provided.

Meanwhile, the multi-layered plastic substrate according to the present invention may be used in a variety of electronic devices. Also, the multi-layered plastic substrate according to the present invention may be used as various packing materials and materials for various containers.

In addition, the present invention provides a method of manufacturing the above-described multi-layered plastic substrate.

In one example, the method may include: a) forming a first organic or organic-inorganic hybrid layer by coating and curing an organic or organic-inorganic hybrid composition on one surface of a plastic film; b) forming a gas barrier layer on the first organic or organic-inorganic hybrid layer; c) forming a multi-layered film by forming a second organic or organic-inorganic hybrid layer by coating and curing an organic or organic-inorganic hybrid composition on the gas barrier layer; d) further manufacturing a multi-layered film the same as that manufactured in step c) by repeating the process from step a) to step c); and e) forming a symmetric structure by joining surfaces of the plastic films not having the multi-layered films manufactured in steps c) and d).

The organic or organic-inorganic hybrid composition used in at least one of steps a) and c) may include at least one selected from the group consisting of at least one organic silane selected from the group consisting of compounds represented by Formula 1, polycaprolactone, polytetrahydrofuran and epoxy xyleneglycol.

[Formula 1] (R¹)ₘ-Si-X₍₄₋ₘ₎

In Formula 1, X may be be the same as and different from each other, and represents hydrogen, halogen, or alkoxy, acyloxy, alkylcarbonyl, alkoxycarbonyl, having 1 to 12 carbon atoms, or -N(R²)₂, wherein R² is hydrogen or alkyl having 1 to 12 carbon atoms, R¹ may be be the same as and different from each other, and represents alkyl, alkenyl, alkynyl, aryl, arylalkyl, alkylaryl, arylalkenyl, alkenylaryl, arylalkynyl, alkynylaryl group, having 1 to 12 carbon atoms, or halogen, substituted amino, amide, aldehyde, ketone, alkylcarbonyl, carboxyl, mercapto, cyano, hydroxyl, alkoxy having 1 to 12 carbon atoms, alkoxycarbonyl having 1 to 12 carbon atoms, sulfonic acid, phosphoric acid, acryloxy, methacryloxy, epoxy, or vinyl group, and m is an integer of 1 to 3.

In one example, in the definition of Formula 1, a structure of -(R¹)ₘ-O-Si-X₍₄₋ₘ₎ or (R¹)ₘ-NR²-Si-X₍₄₋ₘ₎ may be formed by inserting oxygen or -NR³ (here, R³ is hydrogen or alkyl having 1 to 12 carbon atoms) between radical R¹ and Si-.

The composition for forming the organic-inorganic hybrid layer may further include at least one metal alkoxide selected from the group consisting of compounds represented by Formula 2.

[Formula 2] M-(R⁴)_{z}

In Formula 2, M is at least one metal selected from the group consisting of aluminum, zirconium and titanium, R⁴ may be the same as and different from each other, and represents halogen, or alkyl, alkoxy, acyloxy, having 1 to 12 carbon atoms, or hydroxyl, and z is an integer of 3 or 4.

The composition for forming the organic-inorganic hybrid layer may further include at least one of: at least one filler selected from the group consisting of metal, glass powder, diamond powder, silicon oxide, clay, calcium phosphate, magnesium phosphate, barium sulfate, aluminum fluoride, calcium silicate, magnesium silicate, barium silicate, barium carbonate, barium hydroxide, and aluminum silicate; a solvent; and a polymerization catalyst.

A thickness of each of the first and second organic or organic-inorganic hybrid layers may be 0.1 to 50 µm.

In step d), one more multi-layered film having the same structure as that manufactured in step c) is further formed by repeating the process from step a) to step c), and in step e), a symmetric structure is formed by joining surfaces of the plastic films having no multi-layered films formed thereof, thereby manufacturing a multi-layered plastic substrate.

Here, while the previously-manufactured two layers of the multi-layered films are joined, after two layers of plastic films are attached first, to have a symmetric structure based on the two layers of the laminated plastic films, a first organic or organic-inorganic hybrid layer, a gas barrier layer and a second organic or organic-inorganic hybrid layer may be sequentially formed on each surface of each of the two laminated plastic films.

The joining method in step e) may be an adhering method using an acryl-based adhesive or a thermal joining method.

According to such a method of manufacturing a multi-layered plastic substrate having a symmetric structure, the multi-layered plastic substrate that may have high productivity and an excellent moisture barrier property at a low cost, high surface hardness, an excellent gas barrier property, and excellent durability with respect to moisture may be manufactured using a simple process of laminating plastic films.

Hereinafter, the present invention will be described in detail with reference to the accompanying drawings.

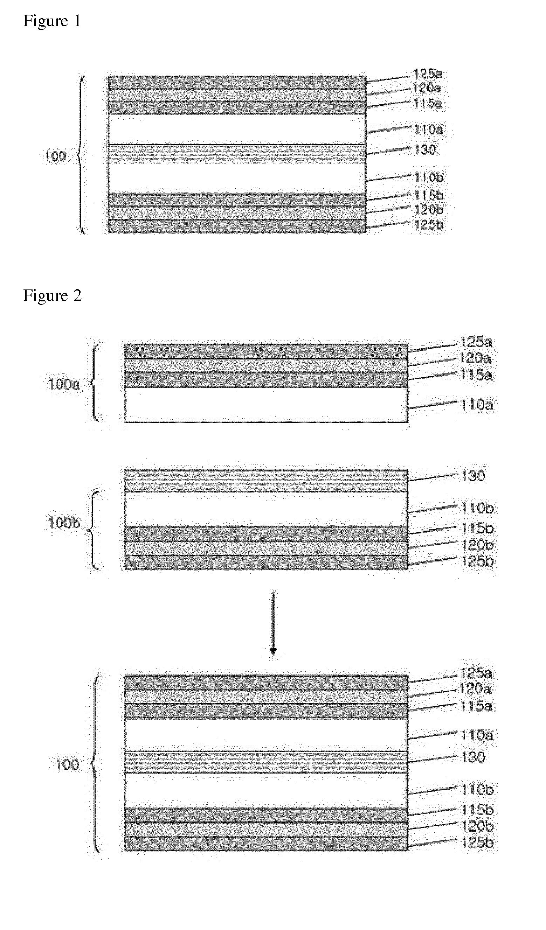

FIG. 1 is a cross-sectional view of a multi-layered plastic substrate of the present invention, and FIG. 2 illustrates a process of manufacturing the substrate.

Referring to FIG. 1, the multi-layered plastic substrate 100 of the present invention has a multi-layered structure combining two layers of plastic films 110a and 110b, two first organic or organic-inorganic hybrid layers 115a and 115b, two gas barrier layers 120a and 120b, and two second organic or organic-inorganic hybrid layers 125a and 125b. In some cases, two layers of the plastic films 110a and 110b may be laminated with a separate adhesive layer 130 to thereby form the multi-layered plastic substrate 100 having a symmetric structure based on the adhesive layer 130.

The multi-layered plastic substrate 100 according to the present invention may be manufactured through various routes. In one example, referring to FIG. 2, an upper laminate 100a of the multi-layered plastic substrate 100 having a structure in which the first organic or organic-inorganic hybrid layer 115a, the gas barrier layer 120a, and the second organic or organic-inorganic hybrid layer 125a are sequentially stacked on the first plastic film 110a may be manufactured. Separately, a lower laminate 100b of the multi-layered plastic substrate 100 having a structure in which the first organic or organic-inorganic hybrid layer 115b, the gas barrier layer 120b, and the second organic or organic-inorganic hybrid layer 125b are sequentially stacked under the second plastic film 110b and the adhesive layer 130 is formed on the second plastic film 110b may be manufactured. Afterward, the multi-layered plastic substrate 100 may be manufactured by laminating the upper laminate 100a with the lower laminate 100b based on the adhesive layer 130.

Hereinafter, the present invention will be described in further detail with reference to Examples. Here, the Examples are intended to explain the present invention and not to limit its scope.

### Example 1

An organic-inorganic hybrid composition was prepared by mixing 20 parts by weight of tetraetoxysilane (TEOS) with 10 parts by weight of glycidoxypropyltrimethoxysilane (GPTMS), adding 7 parts by weight of distilled water, 20 parts by weight of ethanol, and 0.01 parts by weight of HCl thereto, and mixing 100 parts by weight of an epoxy compound (trade name: ERL-4221, Dow Chemical) with 6 parts by weight of triarylsulfonium hexafluoro antimonite salts (mixed at 50w% in propylene carbonate) as a catalyst in a sol prepared by partially hydrolyzing the mixture at 25 °C for 24 hours.

A first organic-inorganic hybrid layer was formed by bar-coating the composition on one surface of a PET film, removing a solvent in a 90 °C convection oven for 5 minutes, UV curing the composition, and thermally curing the composition in a 150 °C convection oven for 1 hour. Afterward, to form a gas barrier layer on the first organic-inorganic hybrid layer that underwent thermal curing, 50 sccm of Ar gas was input using a DC/RF magnetron sputter produced by Atechsystem. Then, the gas was deposited for 10 minutes with RF power (13.56 MHz) at 1000 Watts under a pressure of 5 mtorr, thereby depositing a silicon oxide (SiOx, x is an integer between 1 and 4) thin film to form a gas barrier lyaer. A thickness of the SiOx thin film observed by scanning electron microscopy (SEM) was 100 nm. A second organic-inorganic hybrid layer was formed by bar-coating an organic-inorganic hybrid composition on the formed gas barrier layer, removing a solvent in a 90 °C convection oven for 5 minutes, UV curing the composition, and thermally curing the composition in a 150 °C convection oven for 1 hour.

A first organic-inorganic hybrid layer, a gas barrier layer and a second organic-inorganic hybrid layer were formed on another PET film in the same manner as described above.

A multi-layered plastic substrate was manufactured by joining surfaces of the two PET films, on which the above-mentioned multi-layered structure was not formed, using an acryl-based adhesive.

In the multi-layered plastic substrate obtained after the joining was completed, a thickness of the second organic-inorganic hybrid layer measured with an alpha stepper was 0.5 um. A surface roughness of the second organic-inorganic hybrid layer measured in a room temperature tapping mode according to atomic force microscopy (AFM) was 0.4 nanometers or less in a measurement area of 50 x 50 microns.

The substrate manufactured according to Example 1 was not curved when placed on a flat surface. Main physical properties required for the plastic substrate of Example 1 as a substrate for a display device, including a degree of light penetration, oxygen permeability, moisture permeability, a coefficient of linear expansion and pencil hardness, were measured, and the results are shown in Table 1. A method of measuring each physical property was the same as described above and was applied to all of the Examples and Comparative Examples in the same manner :
1) A degree of light Penetration was measured in a visible ray region, for example, in a range of 380 to 780 nm, using a UV spectrophotometer produced by Varian according to ASTM D1003;
2) Oxygen permeability was measured with 0% relative humidity at room temperature using OX-TRAN 2/20 produced by MOCON by a method according to ASTM D3985;
3) Moisture permeability was measured with 100% relative humidity at room temperature for 48 hours using PERMATRAN-W-3/33 by a method according to ASTM F 1249; and
4) A coefficient of linear expansion was measured at an increasing temperature of 10 °C per minute under a stress of 5 gf using a thermomechinal analyzer (TMA) according to ASTM D696, and pencil hardness was measured under a load of 200 g by a method according to ASTM D3363.

All of the values of the physical properties listed herein were averaged from at least five measured values to have statistical significance.

For reference, oxygen and moisture permeabilites of the PET film used in Example 1 were respectively 25 cc/m²/day/atm and 4.5 g/m²/day, and a coefficient of linear expansion thereof was 22.4 ppm/K.

### Example 2

An organic-inorganic hybrid composition was prepared by the same method as described in Example 1, except that 10 parts by weight of anhydride (MH700G, New Japan Chemical) was additionally input as a curing agent, and then a multi-layered plastic substrate having the same structure as described in Example 1 was formed. Physical properties of the multi-layered plastic substrate were measured, and the results are shown in Table 1.

### Example 3.

An organic-inorganic hybrid composition was prepared by the same method as described in Example 1, except that 80 parts by weight of tetraetoxysilane was mixed with 10 parts by weight of glycidoxypropyltrimethoxysilane, and 28 parts by weight of distilled water, 80 parts by weight of ethanol, and 0.04 parts by weight of HCl were added thereto, and then a multi-layered plastic substrate having the same structure as described in Example 1 was formed. Physical properties of the multi-layered plastic substrate were measured, and the results are shown in Table 1.

### Example 4.

An organic-inorganic hybrid composition was prepared by the same method as described in Example 1, except that 30 parts by weight of colloidal silica (MIBK-SK) was additionally added, and then a multi-layered plastic substrate having the same structure as described in Example 1 was formed. Physical properties of the multi-layered plastic substrate were measured, and the results are shown in Table 1.

### Example 5.

An organic-inorganic hybrid composition was prepared by the same method as described in Example 1, except that 10 parts by weight of metal alkoxide [Al(OBu)₃] was additionally input, 10 parts by weight of distilled water and 30 parts by weight of ethanol were input, 30 parts by weight of colloidal silica (MIBK-ST) was additionally input, and then a multi-layered plastic substrate having the same structure as described in Example 1 was formed. Physical properties of the multi-layered plastic substrate were measured, and the results are shown in Table 1.

### Comparative Example 1.

A multi-layered plastic substrate was manufactured by the same method as described in Example 1, except that a gas barrier layer and a second organic-inorganic hybrid layer were formed only on one surface of a PET film. Physical properties of the manufactured multi-layered plastic substrate were measured and are shown in Table 1.

### Comparative Example 2.

A multi-layered plastic substrate was manufactured by the same method as described in Example 1, except that a first organic-inorganic hybrid layer, a gas barrier layer, and a second organic-inorganic hybrid layer were formed only on both surfaces of a PET film, instead of a structure formed by laminating two PET films. Physical properties of the manufactured multi-layered plastic substrate were measured and are shown in Table 1.

**[Table 1]**

| | Oxygen Permeability ^{a)} (cc/m²/day/atm) | Moisture Permeability ^{b)} (g/m²/day) | Coefficient of Linear Expansion (ppm/K) | Degree of Light Penetration (400nm) | Pencil Hardness (200g load) | Degree of Bending |
|---|---|---|---|---|---|---|
| Example 1 | <0.003 | <0.003 | 20 | 88% | 4H | none |
| Example 2 | <0.003 | <0.003 | 20 | 86% | 4H | none |
| Example 3 | <0.003 | <0.003 | 16 | 88% | 5H | none |
| Example 4 | <0.003 | <0.003 | 12 | 86% | 5H | none |
| Example 5 | <0.003 | <0.003 | 8 | 88% | 6H | none |
| Comparative Example 1 | <0.005 | <0.005 | 25 | 89% | 2H | slight |
| Comparative Example 2 | <0.005 | <0.005 | 25 | 89% | 2H | slight |

| | | | | | | |
|---|---|---|---|---|---|---|
| *The physical properties of the manufactured multi-layered plastic substrate were measured, and are shown in Table 1. In Table 1, a) an oxygen permeability range measurable by an apparatus is 0.001 cc/m²/day/atm, and b) a moisture permeability range measurable by an apparatus is 0.001 g/m²/day. | | | | | | |

Referring to Table 1, compared with Comparative Examples 1 and 2, it can be confirmed that Examples 1 to 5 exhibit low oxygen and moisture permeabilities, a low coefficient of linear expansion, high pencil hardness, and also exhibit no deformation such as a bending phenomenon. It can be also noted that there is no significant difference in the degree of light penetration.

As described above, according to the present invention, a multi-layered plastic substrate which does not inhibit a degree of light penetration, has a low coefficient of linear expansion, improves high temperature thermal deformation due to excellent dimensional stability, and also has an excellent gas barrier property may be provided.

The present invention provides a multi-layered plastic substrate applicable to various fields and a method of manufacturing the same.

According to the present invention, an excellent gas barrier property, high pencil hardness, and a good moisture barrier property can be provided.

While the invention has been shown and described with reference to certain exemplary embodiments thereof, it will be understood by those skilled in the art that various changes in form and details may be made therein without departing from the spirit and scope of the invention as defined by the appended claims.

## Claims

1. A multi-layered plastic substrate, comprising:
a first organic or organic-inorganic hybrid layer; a gas barrier layer; and a second organic or organic-inorganic hybrid layer, which are stacked on both surfaces of two plastic films joined to each other,
wherein at least one of the first organic or organic-inorganic hybrid layer and second organic or organic-inorganic hybrid layer is formed of a composition including at least one selected from the group consisting of at least one organic silane selected from the group consisting of compounds represented by Formula 1, polycaprolactone, polytetrahydrofuran, epoxy and xyleneglycol:
[Formula 1] (R¹)ₘ-Si-X₍₄₋ₘ₎
wherein X is the same as and different from each other, and represents hydrogen, halogen, or alkoxy, acyloxy, alkylcarbonyl, alkoxycarbonyl, having 1 to 12 carbon atoms, or -N(R²)₂, wherein R² is hydrogen or alkyl having 1 to 12 carbon atoms,
R¹ is the same as and different from each other, and represents alkyl, alkenyl, alkynyl, aryl, arylalkyl, alkylaryl, arylalkenyl, alkenylaryl, arylalkynyl, alkynylaryl group, having 1 to 12 carbon atoms, or halogen, substituted amino, amide, aldehyde, ketone, alkylcarbonyl, carboxyl, mercapto, cyano, hydroxyl, alkoxy having 1 to 12 carbon atoms, alkoxycarbonyl having 1 to 12 carbon atoms, sulfonic acid, phosphoric acid, acryloxy, methacryloxy, epoxy, or vinyl group, and
m is an integer of 1 to 3.

2. The multi-layered plastic substrate of claim 1, which has a coefficient of linear expansion of 20 ppm/K or less during measurement under conditions according to ASTM D696, and a pencil hardness of 4H or more under conditions according to ASTM D3363, applying a load of 200 g.

3. The multi-layered plastic substrate of claim 1, wherein in the definition of Formula 1, a structure of -(R¹)ₘ-O-Si-X₍₄₋ₘ₎ or (R¹)ₘ-NR²-Si-X₍₄₋ₘ₎ is formed by inserting oxygen or -NR³ (here, R³ is hydrogen or alkyl having 1 to 12 carbon atoms) between radical R¹ and Si-.

4. The multi-layered plastic substrate of claim 1, wherein at least one of the first organic or organic-inorganic hybrid layer and the second organic or organic-inorganic hybrid layer further includes at least one metal alkoxide selected from the group consisting of compounds represented by Formula 2:
[Formula 2] M-(R⁴)_{z}
wherein M is at least one metal selected from the group consisting of aluminum, zirconium and titanium,
R⁴ is the same as or different from each other, and represents halogen, or alkyl, alkoxy, acyloxy, having 1 to 12 carbon atoms, or hydroxyl, and
z is an integer of 3 or 4.

5. The multi-layered plastic substrate of claim 1, wherein at least one of the first and second organic or organic-inorganic hybrid layers further includes at least one of: at least one filler selected from the group consisting of metal, glass powder, diamond powder, silicon oxide, clay, calcium phosphate, magnesium phosphate, barium sulfate, aluminum fluoride, calcium silicate, magnesium silicate, barium silicate, barium carbonate, barium hydroxide, and aluminum silicate; a solvent; and a polymerization catalyst.

6. The multi-layered plastic substrate of claim 1, wherein each of the first and second organic or organic-inorganic hybrid layers has a thickness of 0.1 to 50 µm.

7. The multi-layered plastic substrate of claim 1, wherein each of the first and second organic or organic-inorganic hybrid layers has a surface roughness of 0.1 to 1.2 Ra.

8. The multi-layered plastic substrate of claim 1, wherein the gas barrier layer is formed of at least one inorganic material selected from the group consisting of SiOₓ (here, x is an integer of 1 to 4), SiOₓN_{y} (here, x and y are integers of 1 to 3, respectively), Al₂O₃ and ITO.

9. The multi-layered plastic substrate of claim 1, wherein the gas barrier layer has a thickness of 5 to 1000 nm.

10. The multi-layered plastic substrate of claim 1, wherein each of the two plastic films has a thickness of 10 to 2000 µm.

11. A method of manufacturing a multi-layered plastic substrate, comprising:
a) forming a first organic or organic-inorganic hybrid layer by coating and curing an organic or organic-inorganic hybrid composition on one surface of a plastic film;
b) forming a gas barrier layer on the first organic or organic-inorganic hybrid layer;
c) forming a multi-layered film by forming a second organic or organic-inorganic hybrid layer by coating and curing an organic or organic-inorganic hybrid composition on the gas barrier layer;
d) further manufacturing a multi-layered film having the same structure as that manufactured in step c) by repeating the process from step a) to step c); and
e) forming a symmetric structure by joining surfaces of the plastic films on which the multi-layered films manufactured in steps c) and d) are not formed,
wherein the organic or organic-inorganic hybrid composition used in at least one of steps a) and c) includes at least one selected from the group consisting of at least one organic silane selected from the group consisting of compounds represented by Formula 1, polycaprolactone, polytetrahydrofuran and epoxy xyleneglycol:
[Formula 1] (R¹)ₘ-Si-X₍₄₋ₘ₎
wherein X is the same as and different from each other, and represents hydrogen, halogen, or alkoxy, acyloxy, alkylcarbonyl, alkoxycarbonyl, having 1 to 12 carbon atoms, or -N(R²)₂, wherein R² is hydrogen or alkyl having 1 to 12 carbon atoms,
R¹ is the same as and different from each other, and represents an alkyl group having 1 to 12 carbon atoms, alkenyl, alkynyl, aryl, arylalkyl, alkylaryl, arylalkenyl, alkenylaryl, arylalkynyl, alkynylaryl group, halogen, substituted amino, amide, aldehyde, ketone, alkylcarbonyl, carboxyl, mercapto, cyano, hydroxyl, alkoxy having 1 to 12 carbon atoms, alkoxycarbonyl having 1 to 12 carbon atoms, sulfonic acid, phosphoric acid, acryloxy, methacryloxy, epoxy, and vinyl group, and
m is an integer of 1 to 3.

12. The method of claim 11, wherein in the definition of Formula 1, a structure of -(R¹)ₘ-O-Si-X₍₄₋ₘ₎ or (R¹)ₘ-NR²-Si-X₍₄₋ₘ₎ is formed by inserting oxygen or -NR³ (here, R³ is hydrogen or alkyl having 1 to 12 carbon atoms) between radical R¹ and Si-.

13. The method of claim 11, at least one of the first organic or organic-inorganic hybrid layer and the second organic or organic-inorganic hybrid layer further includes at least one metal alkoxide selected from the group consisting of compounds represented by Formula 2:
[Formula 2] M-(R⁴)_{z}
wherein M is at least one metal selected from the group consisting of aluminum, zirconium and titanium,
R⁴ is the same as or different from each other, and represents halogen, or alkyl, alkoxy, acyloxy, having 1 to 12 carbon atoms, or hydroxyl, and
z is an integer of 3 or 4.

14. The method of claim 11, wherein the composition for forming the organic-inorganic hybrid layer further includes at least one filler selected from the group consisting of metal, glass powder, diamond powder, silicon oxide, clay, calcium phosphate, magnesium phosphate, barium sulfate, aluminum fluoride, calcium silicate, magnesium silicate, barium silicate, barium carbonate, barium hydroxide, and aluminum silicate; a solvent; and a polymerization catalyst.

15. The method of claim 11, wherein each of the first and second organic or organic-inorganic hybrid layers has a thickness of 0.1 to 50 µm.

16. The method of claim 11, wherein in step e), surfaces of the respective plastic films are joined to each other using an acryl-based adhesive.

17. An electronic device comprising the multi-layered plastic substrate according to one of claims 1 to 9.
